# FASCICULE DE BREVET EUROPEEN

(11) **EP 3 969 971 B1**
(45) Date de publication et mention de la délivrance du brevet: **28.08.2024**
(21) Numéro de dépôt: 20754309.1
(22) Date de dépôt: 23.04.2020
(51) Int. Cl.: G05B 19/418

(54) **CONTRÔLE D'OPÉRATIONS MANUELLES PAR L'INTERMÉDIAIRE D'UN OUTIL À MAIN PORTATIF LORS D'UNE FABRICATION D'UN ASSEMBLAGE DE PIÈCES**
STEUERUNG VON MANUELLEN OPERATIONEN UNTER VERWENDUNG EINES TRAGBAREN HANDWERKZEUGS WÄHREND DER HERSTELLUNG EINER BAUGRUPPE AUS KOMPONENTEN
CONTROL OF MANUAL OPERATIONS USING A PORTABLE HAND TOOL DURING THE MANUFACTURE OF AN ASSEMBLY OF COMPONENTS

(30) Priorité: 13.05.2019 FR 1904977
(43) Date de publication de la demande: 23.03.2022
(73) Titulaire: Inbolt, 91430 Igny (FR)
(72) Inventeur: DUMAS, Louis, 91430 Igny (FR); COHEN, Rudy, 75015 Paris (FR); DERSY, Albane, 92200 Neuilly sur Seine (FR)
(74) Mandataire: Plasseraud IP
(86) Numéro de dépôt international: PCT/FR2020/050687
(87) Numéro de publication internationale: WO 2020/229746

(56) Documents cités:
- EP-A1- 2 916 189
- DE-A1- 102012 219 871

## Description

### Domaine technique

La présente invention concerne de façon générale les opérations de fabrication et/ou de maintenance d'un assemblage de pièces faisant intervenir un outil à main portatif pour permettre à un technicien d'assemblage d'effectuer des opérations manuelles sur des éléments de l'assemblage.

L'outil à main portatif peut être un outil de serrage (clé ou tournevis) adapté pour réaliser des opérations de serrage sur des éléments de serrage tels que des vis et des écrous formant des boulons. L'outil à main portatif peut être également un outil adapté à la pose d'éléments tels que des rivets, ou encore un outil adapté à effectuer des perçages, des soudages ou des découpages à différents endroits de l'assemblage de pièces.

### Arrière-plan technologique

Le contrôle des opérations manuelles effectuées par un technicien d'assemblage au moyen d'un outil à main lors de l'assemblage de pièces est primordial dans de nombreux secteurs de l'industrie, par exemple liés au transport, notamment l'industrie aérospatiale où les processus d'assemblage peuvent être très complexes.

En particulier, le contrôle des opérations de serrage est rendu nécessaire car la complexité des assemblages et le nombre souvent élevé d'éléments de serrage sur lesquels un technicien d'assemblage doit intervenir sont sources d'erreur qui sont difficilement traçables. Parmi les besoins identifiés permettant de garantir la fiabilité d'un assemblage, il est notamment nécessaire de s'assurer que tous les boulons intervenant dans un assemblage prédéfini de pièces ont effectivement été serrés. Il est également nécessaire de garantir que chaque boulon effectivement serré l'a été correctement en termes de couple de serrage. En effet, un boulon trop serré peut endommager les pièces assemblées de manière irréversible. A l'inverse, un boulon trop peu serré peut se dévisser sous l'action de vibrations.

Il est enfin souhaitable de permettre à un technicien d'assemblage de contrôler en temps réel les opérations manuelles qu'il effectue au moyen d'un outil à main lors de la fabrication d'un assemblage de pièces, et d'optimiser le temps qu'il passe à cette fabrication.

On connaît du document US 8, 311, 658 un système de contrôle d'opérations de serrage lors d'une fabrication d'un assemblage de pièces, permettant de localiser chacune des opérations de serrage effectuées par un technicien d'assemblage manipulant un outil de serrage portatif en localisant l'outil de serrage portatif lorsque ce dernier est déplacé à l'emplacement des chacune des opérations de serrage. Pour ce faire, le système utilise des moyens de localisation comprenant d'une part, un émetteur de signaux radiofréquences équipant l'outil de serrage portatif, et d'autre part, une pluralité de balises radiofréquences placées dans l'espace de fabrication de l'assemblage. La position de l'outil de serrage dans un système de coordonnées tridimensionnelles lié à l'espace de fabrication, et donc de l'élément de serrage serré par l'outil de serrage, est obtenue classiquement à partir des signaux radiofréquences émis au niveau de l'outil de serrage et reçus par les balises radiofréquence, par exemple avec des techniques de temps de vol et trilatération. Les signaux radiofréquences émis au niveau de l'outil de serrage peuvent en outre comporter une information relative au statut de chaque opération de serrage, telle qu'une indication que l'opération de serrage a débutée, est en cours et/ou est terminée. Les différentes positions occupées par l'outil de serrage déterminées par les moyens de localisation sont transmises via un réseau de communication (WAN, LAN ou internet) à un système de compte-rendu et d'affichage comprenant notamment des écrans d'équipements portables (téléphones, tablettes) et des écrans d'ordinateurs fixes. Le système de compte-rendu et d'affichage convertit chaque position qu'il reçoit dans le système de coordonnées tridimensionnelles lié à l'espace de fabrication en une position dans un système de coordonnées tridimensionnelles associé à un ensemble de données de modélisation, par exemple un fichier CAO, représentant une image modélisée tridimensionnelle de l'assemblage de pièces. Le système de compte-rendu et d'affichage peut alors commander l'affichage, sur les différents écrans, d'images qui mettent en évidence en temps réel l'emplacement de chaque élément de serrage sur l'image modélisée tridimensionnelle, et le statut de l'opération de serrage associée à chaque élément de serrage. Le système décrit dans le document US 8, 311, 658 permet ainsi de localiser, surveiller et enregistrer à distance le statut des diverses opérations de serrage. En outre, le technicien en charge des opérations de serrage peut également contrôler l'état d'avancement des opérations de serrage.

Ce système présente néanmoins de nombreux inconvénients. Tout d'abord le système est coûteux puisqu'il nécessite l'emploi d'un nombre de balises réceptrices qui peut s'avérer important selon la complexité et les dimensions de l'assemblage à réaliser. De plus, les techniques de localisation se basant sur l'exploitation d'ondes peuvent être biaisées par les environnements de travail dans lesquels évoluent les techniciens d'assemblage. Par exemple, les armatures métalliques et voilages des appareils de l'aéronautique et du spatial créent une cage de Faraday que les ondes ne peuvent traverser. Il est en outre difficile de trouver les bonnes positions des balises qui optimisent la communication entre l'outil de serrage et les balises. Ainsi, une optimisation du protocole de transmission est généralement nécessaire pour s'affranchir du problème de la réflexion des signaux. Enfin, un tel système ne permet pas d'obtenir une précision suffisante requise dans certains cas d'usages pour la localisation (typiquement de l'ordre du millimètre ou inférieure au millimètre).

On connaît également du document EP 2 916 189 A1 un système de contrôle d'opérations sur une pièce avec localisation d'un outil portatif par caméra. L'image acquise par la caméra est comparée à une image CAO de référence de la pièce pour déterminer la localisation de l'outil. Lorsque la pièce est modifiée par des opérations successives, cette comparaison ne permet pas d'obtenir une précision suffisante pour la localisation.

### Résumé de l'invention

Afin de remédier aux inconvénients précités, la présente invention propose une solution à faible coût permettant de localiser et d'identifier très précisément les opérations manuelles effectuées sur des éléments d'un assemblage de pièce par l'intermédiaire d'un outil à main.

Plus particulièrement, la présente invention a pour objet un système de contrôle d'opérations manuelles selon la revendication 1.

Selon d'autres caractéristiques avantageuses et non limitatives du système conforme à l'invention:
- lesdits moyens de localisation peuvent comprendre en outre une centrale inertielle intégrée dans ledit module électronique, le module de traitement étant apte à estimer un déplacement de l'outil à main portatif depuis une dernière position courante estimée et mémorisée à partir de mesures délivrées par ladite centrale inertielle et à estimer au moins une position actualisée dudit outil à main portatif à partir de la dernière position courante et dudit déplacement;
- le module de traitement peut être intégré dans le module électronique, ou dans un équipement distant; dans ce dernier cas, le module électronique comporte des moyens de communication aptes à transmettre les images capturées par la caméra de profondeur et les mesures de ladite centrale inertielle à l'équipement distant pour traitement par le module de traitement ;
- le système peut comporter en outre au moins une interface utilisateur portative apte à indiquer automatiquement audit technicien d'assemblage un paramètre de consigne à appliquer pour ledit élément en fonction de la localisation de l'opération manuelle associée déterminée par lesdits moyens de localisation ;

- ladite au moins une interface utilisateur portative est intégrée dans ledit module électronique, et/ou dans un téléphone et/ou dans une tablette portable ;
- l'interface utilisateur est de préférence un écran d'affichage ;
- le paramètre de consigne est pré-mémorisé dans le module de stockage dudit système mémorisant un ensemble de paramètres de consigne à appliquer sur chacun de ladite pluralité d'éléments dudit assemblage de pièces ;
- le module électronique peut comporter un moyen de validation apte à déclencher une mémorisation automatique d'informations relatives à l'opération manuelle ;
- ce moyen de validation peut être un bouton à commande manuelle dont l'actionnement déclenche ladite mémorisation automatique d'informations relatives à l'opération manuelle ;
- lesdites informations comprennent l'instant de validation, et une référence permettant d'identifier de manière unique l'élément associé à l'opération manuelle ;
- l'outil à main est par exemple une clé ou un tournevis de serrage, une riveteuse, une agrafeuse, une perceuse, une découpeuse ou une soudeuse.

La présente invention a également pour objet un procédé de contrôle d'opérations manuelles selon la revendication 14.

Selon des implémentations possibles du procédé :
- le procédé peut comporter en outre une étape d'estimation d'un déplacement de l'outil à main portatif depuis une dernière position courante estimée et mémorisée à partir de mesures délivrées par une centrale inertielle appartenant audit module électronique, et d'estimation d'au moins une position actualisée dudit outil à main portatif à partir de la dernière position courante et dudit déplacement ;
- le procédé peut comporter en outre une étape de transmission automatique, sur une interface utilisateur portative, d'un paramètre de consigne à appliquer pour ledit élément en fonction de la localisation de l'opération manuelle associée issue de l'étape de détermination ;
- l'étape de transmission consiste de préférence en l'affichage dudit paramètre de consigne sur un écran d'affichage intégré dans ledit module électronique, dans un téléphone et/ou dans une tablette portable.

### Brève description des figures

La description qui va suivre en regard des dessins annexés, donnés à titre d'exemples non limitatifs, fera bien comprendre en quoi consiste l'invention et comment elle peut être réalisée. Sur les figures annexées :
La figure 1 illustre sous forme simplifiée un système de contrôle d'opérations manuelles, en particulier de serrage, selon un premier mode de réalisation possible conforme à l'invention;
La figure 2 illustre sous forme de schéma bloc un module électronique du système de contrôle d'opérations manuelles de la figure 1 ;
La figure 3 illustre sous forme simplifiée un système de contrôle d'opérations manuelles selon autre mode de réalisation possible conforme à l'invention;
La figure 4 illustre des étapes susceptibles d'être mises en oeuvre dans un procédé d'estimation de la position d'un objet mobile à partir d'images capturées par une caméra de profondeur et de données mesurées par une centrale inertielle d'un module électronique fixé ou intégré à l'objet mobile, mis en oeuvre par exemple dans les systèmes de contrôle des opérations manuelles, en particulier de serrage, des figures 1 à 3.

### Description de mode(s) de réalisation

Dans les figures, les éléments identiques ou équivalents porteront les mêmes signes de référence.

Dans la suite, la présente invention va être décrite dans le cadre non limitatif du contrôle d'opérations manuelles de type serrage au moyen d'un outil à main portatif tel qu'un tournevis ou une clé, appelé dans la suite « outil de serrage portatif ». Néanmoins, l'invention s'applique également au contrôle d'autres types d'opérations manuelles faisant intervenir un outil à main. Ainsi, l'outil à main portatif peut être également un outil adapté pour effectuer la pose d'éléments tels que des rivets ou des agrafes, ou encore un outil adapté pour percer des trous à différents endroits de l'assemblage, pour souder différentes pièces de l'assemblage ou découper des pièces de l'assemblage.

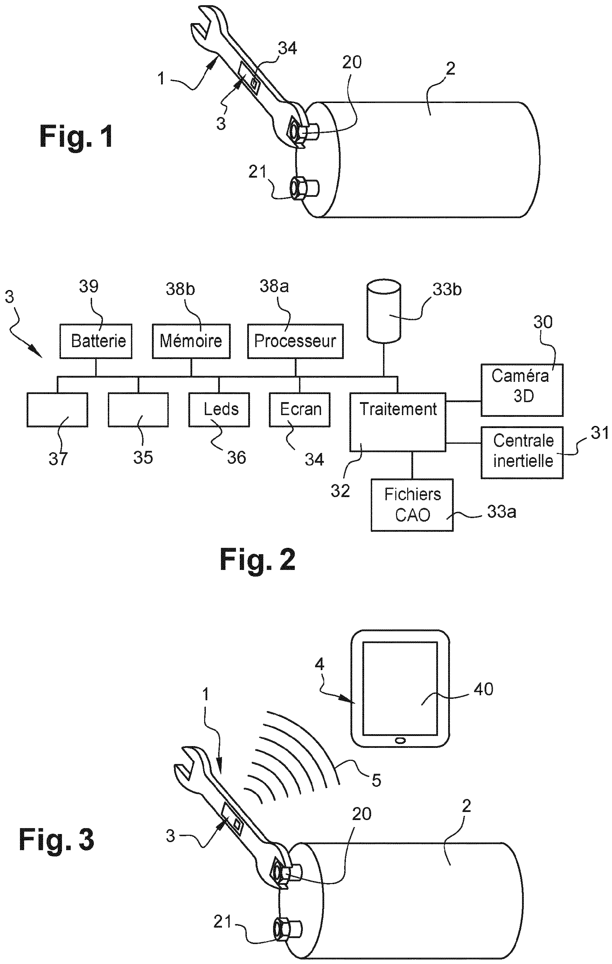

Plusieurs systèmes permettant le contrôle d'opérations de serrage à l'aide d'un outil de serrage portatif vont à présent être décrits en référence aux figures. Tous ces systèmes ont en commun l'utilisation de moyens de localisation intégrés en totalité (figures 1 et 2) ou au moins en partie (figure 3) dans un module électronique fixé à un outil de serrage portatif, ces moyens de localisation étant aptes à déterminer une localisation d'au moins une opération de serrage associée à un élément de serrage en localisant la position de l'outil de serrage portatif, lorsqu'il fait face à l'élément de serrage, dans un système de coordonnées tridimensionnelles associé à un ensemble de données de modélisation représentant une image modélisée tridimensionnelle dudit assemblage de pièces. L'outil de serrage portatif sera décrit dans la suite comme étant une clé de serrage pour écrou. Néanmoins, l'invention s'applique à d'autres types d'outils de serrage adaptés à d'autres types d'éléments de serrage, par un exemple à des tournevis pour le serrage de vis, ou, comme indiqué précédemment, à d'autres types d'outils à main permettant d'autres types d'opérations manuelles, par exemple une agrafeuse, cloueuse, riveteuse, perceuse, soudeuse ou encore découpeuse. L'outil à main peut être tout outil à main pré existant (par exemple une clé de serrage manuelle classique ou dynamométrique) sur lequel le module électronique est postérieurement fixé. En variante, l'outil à main portatif est conçu pour intégrer dès l'origine le module électronique.

La figure 1 illustre schématiquement, à titre d'exemple non limitatif, un outil de serrage portatif, ici une clé de serrage 1 pour écrous, appartenant à un système de contrôle d'opérations manuelles d'un type donné, ici de serrage, lors de la fabrication d'un assemblage de pièces, conformément à un premier mode de réalisation possible de l'invention. Sur la figure 1, la référence 2 représente un exemple d'une pièce qu'un technicien d'assemblage doit assembler dans un assemblage (non représenté) de pièces, ainsi que deux écrous 20, 21 que le technicien doit serrer au moyen de l'outil de serrage portatif 1 pour réaliser l'assemblage de cette pièce. L'outil de serrage portatif 1 comporte un module électronique 3 qui intègre, dans ce premier mode de réalisation, toutes les fonctionnalités permettant au technicien de contrôler en temps réel les opérations de serrage qu'il effectue.

La figure 2 illustre un schéma fonctionnel du module électronique 3 selon ce premier mode de réalisation. Comme indiqué précédemment, le module électronique 3 comporte ici la totalité des moyens de localisation aptes à localiser la position de la clé de serrage 1. Ces moyens de localisation comportent en premier lieu une caméra de profondeur 30 qui capture des images tridimensionnelles de l'environnement de la clé de serrage lorsque le technicien d'assemblage déplace cette clé pour réaliser successivement les différentes opérations de serrage lors de la fabrication de l'assemblage. La caméra de profondeur 30 peut être une caméra de type stéréoscopique, ou une caméra fonctionnant sur le principe du temps de vol (ou caméra TOF, initiales anglo-saxonnes mises pour Time Of Flight), ou encore une caméra dite à lumière structurée. Dans un mode de réalisation particulièrement avantageux pour des raisons qui apparaîtront dans la suite de l'exposé, les moyens de localisation du module électronique 3 peuvent comporter en outre une centrale inertielle 31 apte à délivrer des mesures d'accélérations linéaires selon trois axes orthogonaux liés au module électronique (et donc à la clé de serrage), et de vélocités angulaires. Les moyens de localisation comportent en outre un module de traitement 32 qui reçoit les images tridimensionnelles capturées par la caméra de profondeur 30, et, le cas échant, les mesures effectuées par la centrale inertielle 31. Conformément à la présente invention, le module de traitement 32 comporte un algorithme de calcul permettant d'estimer la position du module électronique 3, et par suite, de la clé de serrage 1, à partir au moins des images tridimensionnelles capturées par la caméra de profondeur 30. La position est estimée dans un repère tridimensionnel lié à une modélisation 3D de l'assemblage, cette modélisation 3D étant obtenue par des données de modélisation tridimensionnelles contenues dans des fichiers de CAO mémorisés dans une mémoire de stockage 33a, comme cela sera expliqué par la suite. Une base de données 33b du module électronique 3 permet d'enregistrer des données relatives aux opérations de serrage, notamment les identifiants des éléments de serrage sur lesquels le technicien intervient lors du processus d'assemblage.

Comme visible sur la figure 2, le module électronique 3 comporte également, dans cet exemple, différentes interfaces utilisateur, notamment un écran d'affichage 34. Les interfaces utilisateur peuvent en outre comprendre un ou plusieurs boutons 35 de commande manuelle, et un ou plusieurs indicateurs visuels 36, tels que des diodes électroluminescentes. Le module électronique 3 comporte également un ou plusieurs modules de communication 37 lui permettant d'échanger des informations avec des équipements extérieurs tels qu'une tablette portable, un PC ou un serveur. Si l'outil à main est un outil connecté (par exemple une clé dynamométrique intelligente), un module de communication peut être prévu pour permettre au module électronique 3 d'échanger des données avec cet outil connecté. Tout protocole de communication filaire (Ethernet...) ou sans fil (Wifi, Bluetooth...) peut être utilisé. La figure 2 montre enfin un microprocesseur 38a et sa mémoire associée 38b, permettant de contrôler le fonctionnement des différents composants du module électronique 3, ainsi qu'une batterie d'alimentation 39.

Le système des figures 1 et 2 peut être utilisé de la façon suivante : Le technicien d'assemblage prend en main la clé de serrage 1 et la déplace jusqu'à ce qu'elle soit en face de l'un des boulons qu'il doit serrer, par exemple le boulon 20 comme représenté sur la figure 1. A partir des images capturées par la caméra de profondeur 30, le module électronique 3 va pouvoir calculer et mémoriser sa position par rapport à la modélisation tridimensionnelle de l'assemblage. Plus précisément, comme cela sera explicité plus en détail par la suite, une position courante du module électronique 3 peut être estimée en alignant des nuages de points extraits d'au moins une image 3D courante délivrée par la caméra de profondeur 30 avec des nuages de points extraits d'une image tridimensionnelle modélisant un état courant de l'assemblage de pièces (par exemple des fichiers CAO), que le module de traitement 32 obtient dans la mémoire de stockage 33a. En variante, les nuages de points extraits d'une image délivrée par la caméra de profondeur 30 peuvent être alignés directement sur un maillage tridimensionnel (« mesh » en terminologie anglo-saxonne) modélisant un état courant de l'assemblage de pièces. Les maillages tridimensionnels peuvent correspondre directement aux fichiers CAO modélisant l'assemblage. Dans tous les cas, le module électronique 3 est susceptible de connaître à tout moment, ou au moins régulièrement, sa position relative par rapport à l'état courant de l'assemblage modélisé. L'estimation faite à partir d'images 3D permet d'obtenir une précision dans la position estimée inférieure au millimètre. Ainsi, lorsque l'outil de serrage 1 fait face à un boulon sur lequel le technicien d'assemblage s'apprête à intervenir, le système permet de localiser et ainsi d'identifier très précisément ce boulon. Comme cela sera explicité par la suite, lorsque le module électronique 3 est équipé en outre de la centrale inertielle 31, le module de traitement 32 peut avantageusement être configuré pour estimer un déplacement de l'outil de serrage 1 depuis une dernière position courante qu'il a estimée et mémorisée à partir d'images capturées par la caméra de profondeur 30, et actualiser la position de l'outil de serrage 1 en fonction de ce déplacement et de cette dernière position courante estimée.

Les paramètres de consigne pour chaque opération manuelle que le technicien doit exécuter peuvent avantageusement avoir été mémorisés au préalable, par exemple dans les fichiers de CAO modélisant l'assemblage mémorisés dans le module de stockage 33a du module électronique 3. Dans l'exemple non limitatif de l'outil de serrage 1, les paramètres sont des consignes de serrage à appliquer pour chaque élément de serrage. Pour un outil à main de type riveteuse, les paramètres de consigne sont relatifs à une force à appliquer. Pour un outil à main de type perceuse, les paramètres de consigne comprennent par exemple le diamètre et/ou la vitesse de rotation du foret. Pour un outil à main de type soudeuse, les paramètres de consigne comprennent par exemple le diamètre et la vitesse du fil, l'intensité et/ou la fréquence de pulsation de l'arc de soudage. Ainsi, dans un mode de réalisation possible, en fonction de la position d'un élément de serrage particulier dans l'assemblage, estimée par le module électronique 3 à partir des images capturées lorsque l'outil de serrage fait face à cet élément, ce module électronique 3 peut récupérer dans le module de stockage 33a la consigne, ici de serrage (typiquement un couple de serrage) adaptée à l'élément de serrage sur lequel le technicien d'assemblage est en train d'intervenir, sur la base de la position estimée, et commander automatiquement l'affichage de cette consigne de serrage sur l'écran 34 du module électronique 3. Il convient de noter que d'autres interfaces utilisateur pourraient être utilisées en complément ou remplacement de l'écran 34, par exemple un indicateur sonore permettant d'indiquer au technicien d'assemblage par un signal sonore le paramètre de consigne de serrage qu'il doit appliquer sur un élément de serrage, fonction de la localisation de l'opération de serrage associée à cet élément de serrage, ou un écran d'affichage déporté sur un équipement distant, par exemple une tablette portative (non représentée sur la figure 1) avec lequel le module électronique 3 peut échanger des informations via un module de communication sans fil utilisant par exemple le protocole Wifi ou Bluetooth.

Dans tous les cas, il en résulte un gain de temps indéniable pour le technicien d'assemblage par rapport à toutes les solutions existantes dans lesquelles un technicien doit consulter en parallèle des documentations pour connaître le paramètre de consigne qu'il doit appliquer pour chaque élément d'un assemblage.

L'indicateur visuel 36, par exemple une diode, peut émettre une lumière de couleur prédéterminée, par exemple verte, de manière à indiquer au technicien d'assemblage qu'il est bien en train d'intervenir sur le bon élément de serrage. Une fois le serrage effectué, le technicien peut valider l'opération de serrage au moyen par exemple d'un bouton 35 à commande manuelle. L'actionnement de ce bouton déclenche alors la mémorisation automatique, de préférence dans la base de données 33b, d'informations relatives à l'opération de serrage que le technicien d'assemblage vient de réaliser. Ces informations comprennent avantageusement un horodatage précis de la fin de l'opération de serrage, correspondant par exemple à l'instant auquel le technicien d'assemblage a validé l'opération de serrage par le bouton 35 (instant de déclenchement du bouton), ainsi qu'une référence permettant d'identifier de manière unique l'élément de serrage associé à l'opération de serrage. En variante à l'actionnement d'un bouton à commande manuelle, la validation d'une opération de serrage et la mémorisation des informations relatives à l'opération de serrage peuvent être automatiques dans certains modes de réalisation : Par exemple, dans le cas où l'outil à main est une clé dynamométrique mécanique, les mesures effectuées par la centrale inertielle 31, lorsque celle-ci est présente, peuvent être utilisées pour identifier une accélération brusque de la clé autour du boulon, correspondant au claquement de la clé lorsque le couple de serrage est atteint. Dans un autre exemple où l'outil à main est une clé dynamométrique connectée, c'est-à-dire apte notamment à transmettre des informations, on peut prévoir que la clé transmette au module électronique 3, via le module de communication 37 configuré avec le protocole de communication adapté à celui utilisé par la clé, l'indication que le couple de serrage entré en consigne a été atteint, ce qui correspond à une validation de l'opération.

Les mesures effectuées par la centrale inertielle 31 peuvent être utilisées pour estimer le couple de serrage effectivement appliqué. En variante, dans le cas où l'outil portatif de serrage 1 est une clé intelligente ou connectée apte à mesurer le couple de serrage qui a été effectivement appliqué, on peut prévoir que le module électronique 3 récupère et mémorise également le couple de serrage tel que mesuré par la clé.

L'actionnement du bouton 35 peut également déclencher l'affichage automatique sur l'écran 34 de la prochaine opération de serrage à réaliser par le technicien d'assemblage, par exemple le serrage du boulon 21 sur la figure 1. Le technicien d'assemblage réitère l'ensemble des opérations décrites précédemment pour chacune des opérations de serrage qu'il doit effectuer sur son assemblage. A l'issue de ces opérations, le technicien d'assemblage peut être invité, par exemple via un message spécifique affiché sur l'écran 34, à prendre une photographie de l'assemblage réalisé. Le bouton de commande manuelle 35 peut servir de déclencheur pour prendre la photographie via la caméra 30. La photographie est avantageusement mémorisée, par exemple dans la base de données 33b. Il est ainsi possible d'avoir une preuve visuelle de la qualité du processus d'assemblage.

Dans le mode de réalisation précédemment décrit, le technicien d'assemblage dispose d'un outil à main complètement autonome permettant de maîtriser, vérifier et surveiller les opérations manuelles sur l'assemblage de pièces.

La figure 3 illustre un autre mode de réalisation d'un système de contrôle d'opérations de serrage conforme à la présente invention. Ce système est similaire au système décrit précédemment en référence aux figures 1 et 2 en ce qu'il comporte un module électronique 3 fixé à l'outil de serrage portatif 1, ce module comportant au moins la caméra de profondeur 30, et de préférence également la centrale inertielle 31. En revanche, le traitement proprement dit des images 3D capturées par la caméra de profondeur et, le cas échéant des mesures de la centrale inertielle, n'est pas ici effectué localement au niveau du module électronique 3, mais au niveau d'un équipement distant 4. Cet équipement distant est de préférence une tablette portative destinée à être utilisée par le technicien d'assemblage. En d'autres termes, le module de traitement 32, le module de stockage 33a et la base de données 33b qui avaient été décrits ci-dessus en référence à la figure 2 ne sont plus ici intégrés au module électronique 3, mais au niveau de l'équipement distant 4 (intégration non représentée sur la figure 3). Toutes les données nécessaires à l'estimation de la position de l'outil par rapport à une modélisation de l'assemblage sont transmises par le module de communication 37 du module électronique 3 à un module de communication correspondant (non représenté) de la tablette portable 4 via une liaison de communication 5, par exemple sans fil de type Wifi ou Bluetooth. Le technicien d'assemblage dispose ainsi de l'écran 40 de l'équipement distant qui est de taille plus grande que l'écran 34 du module 3 de la figure 3, ce qui lui facilite les opérations de contrôle et de suivi. La position courante de l'outil de serrage telle qu'estimée par le module de traitement peut par exemple être visualisée sur l'écran 40 en superposition avec l'image modélisée tridimensionnelle de l'assemblage. Ici encore, une consigne de serrage adaptée à l'élément de serrage sur lequel le technicien d'assemblage s'apprête à intervenir peut avantageusement être récupérée dans les fichiers de modélisation CAO contenus dans la base de données, sur la base de la localisation estimée de l'outil de serrage permettant d'identifier l'élément de serrage, et notifiée au technicien d'assemblage par affichage sur l'écran 40.

Comme dans le système précédemment décrit en référence aux figures 1 et 2, une fois le serrage effectué, l'opération de serrage est validée, soit manuellement par le technicien au moyen du bouton 35 à commande manuelle, soit automatiquement. Dans tous les cas, la validation déclenche la mémorisation automatique, dans la base de données du module électronique 3 et/ou dans la base de données déportée sur l'équipement distant, d'informations relatives à l'opération de serrage que le technicien d'assemblage vient de réaliser.

Un système de contrôle conforme à l'invention permet en conséquence au technicien d'assemblage de pouvoir vérifier en temps réel qu'il a bien serré tous les éléments de serrage, et dans la variante pour laquelle les consignes de serrage adaptées sont par ailleurs fournies automatiquement au technicien, de garantir que chaque élément de serrage a été serré avec le bon paramètre de serrage.

Toutes les informations enregistrées par le module électronique 3 et/ou par l 'équipement distant 4 peuvent être récupérées et affichées à tout moment. Le Tableau 1 ci-après donne un exemple de représentation du statut d'une opération de serrage relative à un élément de serrage donné.

**[Tableau 1]**

| Heure | Référence élément de serrage | Couple de serrage | Statut de l'action de serrage |
|---|---|---|---|
| 11 :57 | 11532 | 120 N.m | OK |

Dans l'exemple ci-dessus, le technicien d'assemblage ou toute autre personne peut vérifier que l'élément de serrage portant la référence 11532 a été serré à 11 h57 (correspondant à l'instant de validation de l'opération de serrage), avec un couple de serrage de consigne ou estimé égal à 120 N.m. D'autres informations peuvent être ajoutées, telles que la date de l'action de serrage, un identifiant associé de manière unique à un technicien d'assemblage.

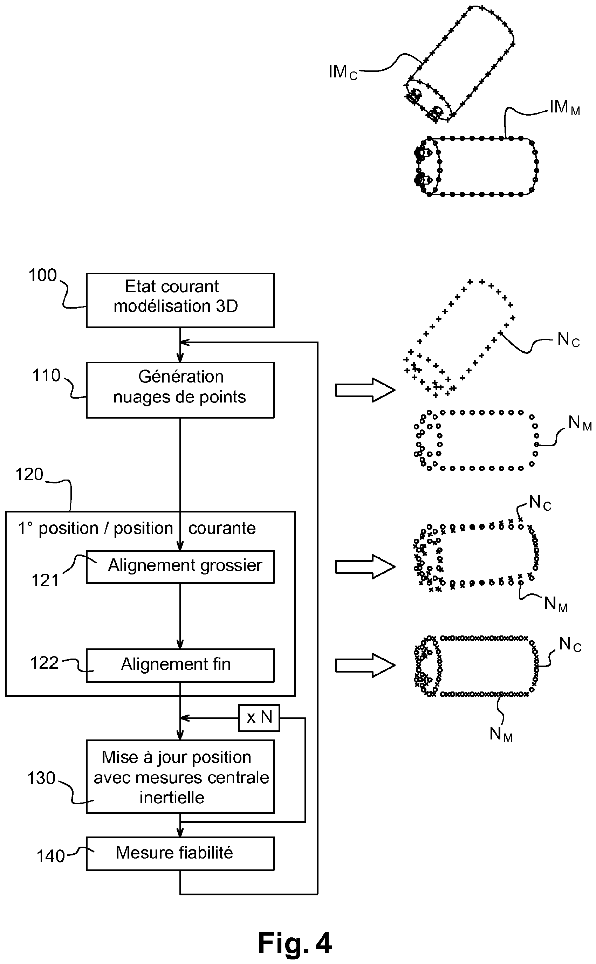

Différentes étapes susceptibles d'être mises en oeuvre dans un procédé de localisation d'un objet mobile dans un environnement donné à partir d'images capturées par une caméra de profondeur et de données mesurées par une centrale inertielle d'un module électronique fixé ou intégré à l'objet mobile vont à présent être détaillées en référence à la figure 4. L'objet mobile que l'on souhaite localiser peut être l'outil à main portatif 1 décrit précédemment dans le cadre non limitatif du contrôle d'opérations manuelles de serrage, auquel cas le procédé de localisation peut être mise en oeuvre par un algorithme de calcul du module de traitement 32 du module électronique 3, ou d'un module de traitement déporté sur un équipement distant 4. Plus généralement, l'objet que l'on souhaite localiser peut être tout objet apte à se mouvoir ou à être déplacé au sein d'un environnement, par exemple l'extrémité d'un bras robotisé.

Dans la suite, on considère de manière non limitative que l'environnement dans lequel l'objet mobile va être localisé correspond à l'espace de fabrication d'un assemblage de pièces.

On rappelle que les données qui sont à disposition pour estimer la localisation du module électronique, et par suite, de l'objet mobile auquel ce module est fixé ou intégré, sont :
- les fichiers de CAO contenant les données permettant de modéliser en trois dimensions l'assemblage de pièces;
- les images tridimensionnelles capturées par la caméra de profondeur ; et
- les mesures délivrées par la centrale inertielle.

Dans le cadre de l'application au contrôle des opérations manuelles telles que le serrage, les fichiers de CAO doivent permettre de modéliser l'assemblage de pièces à différents stades du processus d'assemblage. En d'autres termes, on dispose de données de modélisation permettant de construire différentes maquettes numériques représentatives de l'assemblage à différents stades de fabrication de cet assemblage.

L'objectif de l'algorithme décrit ci-dessous est d'identifier la position relative du module électronique intégrant la caméra de profondeur et la centrale inertielle, dans un repère tridimensionnel associé à la maquette numérique correspondant à un état courant de l'assemblage de pièces.

### 1. Détermination de la maquette numérique correspondant à l'état courant modélisé de l'assemblage (Etape 100 sur la figure 4) :

Comme indiqué précédemment, l'assemblage peut être dans plusieurs états en fonction des pièces qui ont été assemblées ou non. Pour obtenir la position, l'algorithme a besoin de connaître l'état courant de la maquette numérique car il compare ce qui est observé par la caméra de profondeur avec ce qui est observé numériquement, c'est-à-dire avec une image modélisée tridimensionnelle représentative de l'état courant de l'assemblage de pièces. La maquette numérique courante peut être directement renseignée par un tiers (opérateur, logiciel de suivi de productions) qui sélectionne parmi les fichiers CAO celui qui représente l'état courant de la maquette numérique. En variante, la maquette numérique courante est déterminée à partir d'une sélection de points d'intérêts extraits d'une image tridimensionnelle courante fournie par la caméra de profondeur, auxquels on associe des paramètres locaux calculés selon les techniques traditionnellement utilisées dans la reconnaissance d'objet 2D/3D. Pour déterminer l'état courant modélisé de l'assemblage, on compare les paramètres locaux calculés avec des paramètres obtenus de la même manière en simulant numériquement ce que voit la caméra à partir des modélisations 3D aux différents stades de l'assemblage.

Sur la partie droite de la figure 4, on a illustré un exemple d'une image courante tridimensionnelle Im_{C} d'un assemblage réel, capturée par la caméra de profondeur, et de l'image tridimensionnelle modélisée Im_{M} correspondant à l'état courant modélisé de l'assemblage. Sur cet exemple, l'assemblage considéré correspond à la pièce 2 et aux écrous 20, 21 des figures 1 et 3.

### 2. Génération des nuages de points et détermination d'une première position/position courante du module (Etapes 110 et 120 sur la figure 4) :

Le principe général appliqué pour déterminer la position relative du module par rapport à la maquette numérique consiste à rechercher la transformation nécessaire pour aligner l'image tridimensionnelle capturée Im_{C} avec l'image tridimensionnelle modélisée Im_{M}. En pratique, l'algorithme de calcul est configuré pour extraire, lors d'une étape 110 :
- d'une part, un nuage de points de l'image tridimensionnelle courante capturée par la caméra de profondeur (nuage de points dit « source »); et
- d'autre part, un nuage de points de l'image tridimensionnelle modélisée (nuage de points dit « cible »).

La partie droite de la figure 4 illustre un nuage de points « source » N_{C} extrait de l'image tridimensionnelle courante Im_{C} et un nuage de points « cible » N_{M} extrait de l'image tridimensionnelle modélisée Im_{M}.

Pour obtenir une représentation la plus précise possible du nuage de points « source » et faciliter ainsi l'alignement des deux nuages de points, l'étape 110 va utiliser de préférence plusieurs images capturées successivement par la caméra de profondeur durant une période donnée, chaque image capturée étant convertie en un nuage de points. Les instants de capture de ces images successives sont de préférence suffisamment rapprochés (correspondant par exemple à une fréquence de capture de 30 images par seconde) pour que les différentes prises de vue soient similaires. Les nuages de points obtenus par ces prises de vue successives sont ensuite alignés de façon à ne former qu'un seul nuage de points « source ». Pour aligner ces nuages de points et former le nuage de points source, l'étape 110 va calculer le déplacement relatif entre chaque prise de vue à partir des mesures délivrées par la centrale inertielle. En procédant ainsi, on obtient avantageusement une très forte densité de points tout en diminuant le bruit numérique potentiellement créé par la caméra de profondeur.

Le processus d'alignement du nuage de points « source » avec le nuage de points « cible » s'effectue de préférence en deux temps, en procédant d'abord à un alignement grossier (sous étape 121), puis à un raffinement de l'alignement (sous étape 122).

Pour la mise en oeuvre de l'alignement grossier, la sous-étape 121 comporte par exemple une sélection aléatoire d'une pluralité de points dans le nuage de points « source ». On appaire chaque point sélectionné avec le point du nuage de points « cible » qui possède des paramètres locaux les plus proches de ceux associés au point sélectionné, et on cherche à optimiser la transformation qui minimise les distances entre les points d'une même paire.

La partie droite de la figure 4 en regard de la sous-étape 121 illustre le résultat d'un alignement grossier du nuage de points « source » N_{C} extrait de l'image tridimensionnelle courante Im_{C} et du nuage de points « cible » N_{M} extrait de l'image tridimensionnelle modélisée Im_{M}.

Partant de l'alignement trouvé à la sous étape 121, la sous-étape 122 met en oeuvre un algorithme de type ICP (initiales anglo-saxonnes mises pour itérative Closest Point), lequel consiste à associer chaque point du nuage de points « source » avec le point le plus proche, en termes de distance euclidienne, du nuage de points « cible », puis à recherche itérativement les transformations nécessaires pour minimiser la distance entre chaque point appairé. A chaque itération de l'optimisation, les points sont ré-associés.

A l'issue de la sous-étape 122, le module électronique connaît la transformation nécessaire à l'obtention de l'alignement des points des nuages, et par suite, en déduit sa position dans le repère tridimensionnel lié à l'image modélisée.

Comme indiqué précédemment, dans une variante d'implémentation du procédé, on peut aligner les nuages de points extraits d'une image délivrée par la caméra de profondeur 30 non pas sur des nuages de points modélisant l'assemblage, mais directement sur un maillage tridimensionnel (« mesh » en terminologie anglo-saxonne) modélisant un état courant de l'assemblage de pièces.

### 3. Mise à jour de la position par mesure de l'accélération (étape 130 de la figure 4) :

Pour ne pas avoir à réitérer trop souvent les étapes 110 à 120 qui sont coûteuses en temps de calcul, l'algorithme de calcul va avantageusement actualiser la position en calculant, lors de l'étape 130, le déplacement du module par rapport à la position précédemment enregistrée à partir de mesures délivrées par ladite centrale inertielle. La position peut ainsi être actualisée, en utilisant par exemple classiquement un filtrage de Kalman.

Pour chaque mise à jour de la position, une nouvelle image tridimensionnelle est cependant capturée par la caméra de profondeur. Cette image peut être avantageusement transformée en nuage de points et être alignée avec le nuage de point « cible » à partir du déplacement précédemment calculé, puis ajoutée au nuage de points « source ». Pour éviter que le nuage de points « source » contienne un nombre trop important de points, ce qui pourrait engendrer des problèmes de mémoire, l'algorithme peut avantageusement filtrer le nuage « source » en supprimant de manière aléatoire des points lorsqu'une zone est trop dense. Une sélection plus intelligente des points en surplus peut également être envisagée en enlevant en priorité des points qui sont peu cohérents et/ou en remplaçant des petits ensembles denses de points par leurs barycentres.

L'étape 130 peut être réitérée un certain nombre de fois, par exemple un nombre prédéterminé N de fois, comme indiqué sur la figure 4. Néanmoins, le calcul du déplacement perd grandement en précision au cours du temps, du fait notamment que les mesures de l'accélération sont intégrées deux fois pour calculer le déplacement. Pour contrer ce phénomène, au bout de N itérations, l'algorithme de calcul peut procéder avantageusement à un ré-alignement de tous les nuages de points acquis par la caméra de profondeur pendant l'étape 130, sur le nuage de points « cible », en utilisant par exemple un algorithme de type ICP.

### 4. Fiabilité de la position estimée (étape 140 sur la figure 4) :

La mise à jour de l'estimation de la position du module électronique par utilisation des mesures délivrées par la centrale inertielle peut être effectuée tant que la position estimée est considérée fiable. Il est donc souhaitable de contrôler périodiquement la fiabilité de l'estimation. Pour ce faire, l'algorithme de calcul peut être avantageusement configuré, lors d'une étape 140, pour aligner un nuage de points extrait d'une image capturée par la caméra avec le nuage de points « source » à partir de sa position telle qu'estimée. La fiabilité de la position est alors définie comme la somme des distances euclidiennes de chaque point du nuage « source » par rapport au nuage « cible ». Si la fiabilité passe au-dessus d'un certain seuil prédéfini, l'estimation de la position par l'utilisation des mesures de la centrale inertielle doit être considérée comme peu fiable. L'algorithme de calcul est alors configuré pour recommencer les étapes à partir de l'étape 110.

Le fait d'associer les mesures de la centrale inertielle au traitement des images capturées par la caméra de profondeur peut présenter de nombreux intérêts, outre le gain en termes de coûts de calculs. Ainsi par exemple, dans le cadre de l'application du module électronique au contrôle des opérations de serrage lors d'un assemblage de pièces, la caméra de profondeur peut ne pas donner des images suffisamment nettes pour des objets situés trop près. Les mesures délivrées par la centrale inertielle permettent ainsi de combler les périodes pendant lesquelles la caméra pourrait être insuffisante, en permettant d'estimer une position de l'outil de serrage portatif même lorsque ce dernier est au plus près de l'élément de serrage. Par ailleurs, bien qu'une caméra de profondeur permette d'obtenir déjà une précision de l'ordre du millimètre dans l'estimation de la position, le gain en précision peut encore être amélioré en associant les mesures d'accélération pour une mise à jour de la position estimée, par exemple par filtrage de Kalman.

## Revendications

1. Système de contrôle d'opérations manuelles lors d'une fabrication d'un assemblage de pièces, le système comportant un outil à main portatif (1) permettant à un technicien d'assemblage d'effectuer des opérations manuelles sur une pluralité d'éléments (20, 21) dudit assemblage de pièces, et des moyens de localisation intégrés au moins en partie dans un module électronique (3) fixé audit outil à main portatif (1), lesdits moyens de localisation étant aptes à déterminer une localisation d'au moins une opération manuelle associée à un élément (20, 21) en localisant la position dudit outil à main portatif (1) dans un système de coordonnées tridimensionnelles lié à une modélisation tridimensionnelle dudit assemblage de pièces, **caractérisé en ce que** le système de contrôle comporte une mémoire de stockage (33a) contenant une pluralité de fichiers CAO permettant de construire des images modélisées tridimensionnelles de l'assemblage de pièces à différents stades de la fabrication,
et **en ce que** lesdits moyens de localisation comprennent une caméra de profondeur (30) appartenant audit module électronique (3) et un module de traitement (32) apte à estimer et mémoriser une position courante dudit outil à main portatif (1), ladite position courante étant estimée en alignant des nuages de points extraits d'au moins une image courante capturée par ladite caméra de profondeur (30) avec un maillage ou des nuages de points extraits d'une image modélisée tridimensionnelle représentative d'un état courant dudit assemblage de pièces, ladite image modélisée tridimensionnelle représentative d'un état courant étant construite à partir d'un fichier CAO parmi la pluralité de fichiers CAO contenus dans la mémoire de stockage (33a).

2. Système selon la revendication 1, **caractérisé en ce que** lesdits moyens de localisation comprennent en outre une centrale inertielle (31) intégrée dans ledit module électronique (3), et **en ce que** le module de traitement (32) est apte à estimer un déplacement de l'outil à main portatif (1) depuis une dernière position courante estimée et mémorisée à partir de mesures délivrées par ladite centrale inertielle (31) et à estimer au moins une position actualisée dudit outil à main portatif (1) à partir de la dernière position courante et dudit déplacement.

3. Système selon l'une quelconque des revendications précédentes, **caractérisé en ce que** le module de traitement (32) est intégré dans le module électronique (3).

4. Système selon l'une quelconque des revendications 1 à 2, **caractérisé en ce que** le module de traitement (32) est intégré dans un équipement distant (4).

5. Système selon la revendication 4 combinée à la revendication 2, **caractérisé en ce que** ledit module électronique (32) comporte des moyens de communication (37) aptes à transmettre les images capturées par la caméra de profondeur (30) et les mesures de ladite centrale inertielle (31) à l'équipement distant (4) pour traitement par le module de traitement (32).

6. Système selon l'une quelconque des revendications précédentes, **caractérisé en ce qu'**il comporte en outre au moins une interface utilisateur portative (34, 40) apte à indiquer automatiquement audit technicien d'assemblage un paramètre de consigne à appliquer pour ledit élément (20, 21) en fonction de la localisation de l'opération manuelle associée déterminée par lesdits moyens de localisation.

7. Système selon la revendication 6, **caractérisé en ce que** ladite au moins une interface utilisateur portative (34, 40) est intégrée dans ledit module électronique (3), et/ou dans un téléphone et/ou dans une tablette portable.

8. Système selon l'une quelconque des revendications 6 à 7, **caractérisé en ce que** l'interface utilisateur est un écran d'affichage.

9. Système selon l'une quelconque des revendications 6 à 8, **caractérisé en ce que** ledit paramètre de consigne est pré-mémorisé dans le module de stockage (33a) dudit système mémorisant un ensemble de paramètres de consigne à appliquer sur chacun de ladite pluralité d'éléments (20, 21) dudit assemblage de pièces.

10. Système selon l'une quelconque des revendications précédentes, **caractérisé en ce que** le module électronique (3) comporte un moyen de validation apte à déclencher une mémorisation automatique d'informations relatives à l'opération manuelle.

11. Système selon la revendication 10, **caractérisé en ce que** le moyen de validation est un bouton (35) à commande manuelle dont l'actionnement déclenche ladite mémorisation automatique d'informations relatives à l'opération manuelle.

12. Système selon l'une quelconque des revendications 10 ou 11, **caractérisé en ce que** lesdites informations comprennent l'instant de validation, et une référence permettant d'identifier de manière unique l'élément associé à l'opération manuelle.

13. Système selon l'une quelconque des revendications précédentes, **caractérisé en ce que** l'outil à main (1) est une clé ou un tournevis de serrage, une riveteuse, une agrafeuse, une perceuse, une découpeuse ou une soudeuse.

14. Procédé de contrôle d'opérations manuelles lors d'une fabrication d'un assemblage de pièces, le procédé comportant les étapes suivantes:
- utilisation par un technicien d'assemblage d'un outil à main portatif (1) pour effectuer des opérations manuelles sur une pluralité d'éléments (20, 21) dudit assemblage de pièces ; et
- détermination d'une localisation d'une opération manuelle associée à un élément (20, 21) en localisant la position dudit outil à main portatif (1) dans un système de coordonnées tridimensionnelles lié à une modélisation tridimensionnelle dudit assemblage de pièces, **caractérisé**
**en ce que** le procédé comprend une étape de stockage dans une mémoire de stockage d'une pluralité de fichiers CAO permettant de construire des images modélisées tridimensionnelles de l'assemblage de pièces à différents stades de la fabrication
et **en ce que** l'étape de détermination comprend des captures d'images par une caméra de profondeur (30) appartenant à un module électronique (3) fixé audit outil à main portatif (1) et une étape d'estimation (110-120) et de mémorisation d'une position courante dudit outil à main portatif (1) en alignant des nuages de points extraits d'au moins une image courante capturée par ladite caméra de profondeur (30) avec un maillage ou des nuages de points extraits d'une image modélisée tridimensionnelle représentative d'un état courant dudit assemblage de pièces, ladite image modélisée tridimensionnelle représentative d'un état courant étant construite à partir d'un fichier CAO parmi la pluralité de fichiers CAO contenus dans la mémoire de stockage (33a).

15. Procédé selon la revendication 14, **caractérisé en ce qu'**il comporte en outre une étape (130) d'estimation d'un déplacement de l'outil à main portatif (1) depuis une dernière position courante estimée et mémorisée à partir de mesures délivrées par une centrale inertielle (31) appartenant audit module électronique (3), et d'estimation d'au moins une position actualisée dudit outil à main portatif (1) à partir de la dernière position courante et dudit déplacement.

16. Procédé selon l'une quelconque des revendications 14 à 15, **caractérisé en ce qu'**il comporte en outre une étape de transmission automatique, sur une interface utilisateur portative (34, 40), d'un paramètre de consigne à appliquer pour ledit élément en fonction de la localisation de l'opération manuelle associée issue de l'étape de détermination.

17. Procédé selon la revendication 16, **caractérisé en ce que** l'étape de transmission consiste en l'affichage dudit paramètre de consigne sur un écran d'affichage intégré dans ledit module électronique (3), dans un téléphone et/ou dans une tablette portable (4).

## Patentansprüche

1. System zur Kontrolle manueller Arbeitsgänge bei der Herstellung einer Teilebaugruppe, wobei das System ein tragbares Handwerkzeug (1) umfasst, das es einem Montagetechniker ermöglicht, manuelle Arbeitsgänge an einer Vielzahl von Elementen (20, 21) der Teilebaugruppe durchzuführen, und Lokalisierungsmittel umfasst, die wenigstens teilweise in ein elektronisches Modul (3) integriert sind, das an dem tragbaren Handwerkzeug (1) befestigt ist, wobei die Lokalisierungsmittel dazu geeignet sind, eine Lokalisierung wenigstens eines manuellen Arbeitsgangs zu bestimmen, der einem Element (20, 21) zugeordnet ist, durch Lokalisierung der Position des tragbaren Handwerkzeugs (1) in einem dreidimensionalen Koordinatensystem, das mit einer dreidimensionalen Modellierung der Teilebaugruppe verbunden ist,
**dadurch gekennzeichnet, dass** das Kontrollsystem einen Speicher (33a) umfasst, der eine Vielzahl von CAD-Dateien enthält, die es ermöglichen, dreidimensionale modellierte Bilder der Teilebaugruppe in verschiedenen Stadien der Herstellung zu konstruieren,
und dass die Lokalisierungsmittel eine Tiefenkamera (30) umfassen, die zu dem elektronischen Modul (3) gehört, und ein Verarbeitungsmodul (32) umfassen, das dazu geeignet ist, eine aktuelle Position des tragbaren Handwerkzeugs (1) zu schätzen und zu speichern, wobei die aktuelle Position geschätzt wird, indem Punktwolken, die aus wenigstens einem von der Tiefenkamera (30) erfassten aktuellen Bild extrahiert wurden, mit einem Punktenetz oder Punktewolken ausgerichtet werden, die aus einem dreidimensionalen Modellbild extrahiert wurden, das einen aktuellen Zustand der Teilebaugruppe darstellt, wobei das dreidimensionale Modellbild, das einen aktuellen Zustand darstellt, ausgehend von einer CAD-Datei aus der Vielzahl von CAD-Dateien, die in dem Speicher (33a) enthalten sind, konstruiert wurde.

2. System nach Anspruch 1, **dadurch gekennzeichnet, dass** die Mittel zur Lokalisierung ferner ein Trägheitssystem (31) umfassen, das in das elektronische Modul (3) integriert ist, und dass das Verarbeitungsmodul (32) dazu geeignet ist, eine Verschiebung des tragbaren Handwerkzeugs (1) von einer letzten aktuellen Position aus zu schätzen, die anhand der von dem Trägheitssystem (31) gelieferten Messungen geschätzt und gespeichert wurde, und wenigstens eine aktualisierte Position des tragbaren Handwerkzeugs (1) anhand der letzten aktuellen Position und der Verschiebung zu schätzen.

3. System nach einem der vorhergehenden Ansprüche, **dadurch gekennzeichnet, dass** das Verarbeitungsmodul (32) in das elektronisches Modul (3) integriert ist.

4. System nach einem der Ansprüche 1 bis 2, **dadurch gekennzeichnet, dass** das Verarbeitungsmodul (32) in ein entferntes Gerät (4) integriert ist.

5. System nach Anspruch 4 in Kombination mit Anspruch 2, **dadurch gekennzeichnet, dass** das Elektronikmodul (32) Kommunikationsmittel (37) umfasst, die dazu geeignet sind, die von der Tiefenkamera (30) erfassten Bilder und die Messungen des Trägheitssystems (31) zu dem entfernten Gerät (4) zur Verarbeitung durch das Verarbeitungsmodul (32) zu übertragen.

6. System nach einem der vorhergehenden Ansprüche, **dadurch gekennzeichnet, dass** es ferner wenigstens eine tragbare Benutzerschnittstelle (34, 40) umfasst, die dazu geeignet ist, dem Montagetechniker automatisch einen Sollparameter anzuzeigen, der für das Element (20, 21) in Abhängigkeit von dem Ort des zugehörigen manuellen Arbeitsgangs, die durch die Lokalisierungsmittel bestimmt wird, anzuwenden ist.

7. System nach Anspruch 6, **dadurch gekennzeichnet, dass** die wenigstens eine tragbare Benutzerschnittstelle (34, 40) in das elektronische Modul (3) und/oder in ein Telefon und/oder in ein tragbares Tablet integriert ist.

8. System nach einem der Ansprüche 6 bis 7, **dadurch gekennzeichnet, dass** die Benutzerschnittstelle ein Display ist.

9. System nach einem der Ansprüche 6 bis 8, **dadurch gekennzeichnet, dass** der Sollwertparameter in dem Speichermodul (33a) des Systems vorgespeichert ist, das einen Satz von Sollwertparametern speichert, die auf jedes der mehreren Elemente (20, 21) derTeilebaugruppe angewendet werden sollen.

10. System nach einem der vorhergehenden Ansprüche, **dadurch gekennzeichnet, dass** das elektronische Modul (3) ein Validierungsmittel umfasst, das dazu geeignet ist, eine automatische Speicherung von Informationen über den manuellen Arbeitsgang auszulösen.

11. System nach Anspruch 10, **dadurch gekennzeichnet, dass** das Validierungsmittel ein manuell bedienbarer Knopf (35) ist, dessen Betätigung die automatische Speicherung von Informationen über den manuellen Arbeitsgang auslöst.

12. System nach einem der Ansprüche 10 oder 11, **dadurch gekennzeichnet, dass** die Informationen den Zeitpunkt der Validierung und eine Referenz zur eindeutigen Identifizierung des mit dem manuellen Arbeitsgang verbundenen Elements umfassen.

13. System nach einem der vorhergehenden Ansprüche, **dadurch gekennzeichnet, dass** das Handwerkzeug (1) ein Schraubenschlüssel oder -dreher, ein Nietgerät, ein Heftgerät, eine Bohrmaschine, ein Schneidegerät oder ein Schweißgerät ist.

14. Verfahren zur Kontrolle manueller Arbeitsgänge bei der Herstellung einer Teilebaugruppe, wobei das Verfahren die folgenden Schritte umfasst:
- Verwendung eines tragbaren Handwerkzeugs (1) durch einen Montagetechniker, um manuelle Arbeitsgänge an einer Vielzahl von Elementen (20, 21) der Teilebaugruppe durchzuführen; und
- Bestimmen eines Ortes eines manuellen Arbeitsgangs, der mit einem Element (20, 21) verbunden ist, durch Lokalisieren der Position des tragbaren Handwerkzeugs (1) in einem dreidimensionalen Koordinatensystem, das mit einer dreidimensionalen Modellierung der Teilebaugruppe verbunden ist, **dadurch gekennzeichnet, dass** das Verfahren einen Schritt des Speicherns einer Vielzahl von CAD-Dateien in einem Speicher umfasst, die es ermöglichen, dreidimensionale modellierte Bilder des Zusammenbaus von Teilen in verschiedenen Stadien der Herstellung zu konstruieren,
- und dass der Bestimmungsschritt Bilderfassungen durch eine Tiefenkamera (30) umfasst, die zu einem elektronischen Modul (3) gehört, das an dem tragbaren Handwerkzeug (1) befestigt ist, sowie einen Schritt des Schätzens (110-120) und Speicherns einer aktuellen Position des tragbaren Handwerkzeugs (1) durch Ausrichten von Punktewolken, die aus wenigstens einem aktuellen, von der Tiefenkamera (30) erfassten Bild extrahiert werden, mit einem Punktenetz oder Punktwolken, die aus einem dreidimensionalen Modellbild extrahiert wurden, das einen aktuellen Zustand der Teilebaugruppe darstellt, wobei das dreidimensionale Modellbild, das einen aktuellen Zustand darstellt ist, ausgehend von einer CAD-Datei aus der Vielzahl von CAD-Dateien, die in dem Speicher (33a) enthalten sind, konstruiert wurde.

15. Verfahren nach Anspruch 14, **dadurch gekennzeichnet, dass** es ferner einen Schritt (130) des Schätzens einer Verschiebung des tragbaren Handwerkzeugs (1) von einer letzten aktuellen Position aus umfasst, die anhand von von einem Trägheitssystem (31) gelieferten Messungen geschätzt und gespeichert wurde, die zu dem elektronischen Modul (3) gehört, und des Schätzens wenigstens einer aktualisierten Position des tragbaren Handwerkzeugs (1) anhand der letzten aktuellen Position und der Verschiebung.

16. Verfahren nach einem der Ansprüche 14 bis 15, **dadurch gekennzeichnet, dass** es ferner einen Schritt umfasst, bei dem auf einer tragbaren Benutzerschnittstelle (34, 40) automatisch ein Sollparameter übertragen wird, der für das Element in Abhängigkeit von dem Ort des zugehörigen manuellen Arbeitsgangs aus dem Bestimmungsschritt anzuwenden ist.

17. Verfahren nach Anspruch 16, **dadurch gekennzeichnet, dass** der Übertragungsschritt darin besteht, den Sollparameter auf einem in das elektronische Modul (3), in ein Telefon und/oder in ein tragbares Tablet (4) integrierten Anzeigebildschirm anzuzeigen.

## Claims

1. System for controlling manual operations during production of an assembly of parts, the system comprising a portable hand tool (1) allowing an assembly technician to perform manual operations on a plurality of elements (20, 21) of said assembly of parts, and locating means integrated at least in part into an electronic module (3) attached to said portable hand tool (1), said locating means being able to determine a location of at least one manual operation associated with an element (20, 21) by locating the position of said portable hand tool (1) in a three-dimensional coordinate system linked to a three-dimensional model of said assembly of parts, **characterized in that** the controlling system comprises a storage memory (33a) containing a plurality of CAD files allowing the construction of three-dimensional modelled images of the assembly of parts at various stages in production,
and **in that** said locating means comprise a depth camera (30) belonging to said electronic module (3) and a processing module (32) able to estimate and save a current position of said portable hand tool (1), said current position being estimated by aligning point clouds extracted from at least one current image captured by said depth camera (30) with a mesh or point clouds extracted from a three-dimensional modelled image representative of a current state of said assembly of parts, said three-dimensional modelled image representative of a current state being constructed on the basis of one CAD file from among the plurality of CAD files contained in the storage memory (33a).

2. System according to claim 1, wherein said locating means further comprise an inertial measurement unit (31) integrated into said electronic module (3), and in that the processing module (32) is able to estimate a movement of the portable hand tool (1) from a last estimated and saved current position on the basis of measurements delivered by said inertial measurement unit (31) and to estimate at least one updated position of said portable hand tool (1) on the basis of the last current position and said movement.

3. System according to any one of the preceding claims, **characterized in that** the processing module (32) is integrated into the electronic module (3).

4. System according to any one of claims 1 to 2, **characterized in that** the processing module (32) is integrated into a remote apparatus (4).

5. System according to claim 4 merged with claim 2, **characterized in that** the processing module (32) comprises communication means (37) able to transmit the images captured by the depth camera (30) and the measurements from said inertial measurement unit (31) to the remote apparatus (4) for processing by the processing module (32).

6. System according to any one the preceding claims, **characterized in that** it further comprises at least one portable user interface (34, 40) able to automatically indicate to said assembly technician a setpoint parameter to be applied for said element (20, 21) according to the location of the associated manual operation determined by said locating means.

7. System according to claim 6, **characterized in that** said at least one portable user interface (34, 40) is integrated into said electronic module (3), and/or into a mobile telephone and/or into a portable tablet.

8. System according to any one of claims 6 to 7, **characterized in that** the user interface is a display screen.

9. System according to any one of claims 6 to 8, **characterized in that** said setpoint parameter is pre-saved in the storage module (33a) of said system saving a set of setpoint parameters to be applied to each of said plurality of elements (20, 21) of said assembly of parts.

10. System according to any one the preceding claims, **characterized in that** the electronic module (3) comprises validation means able to trigger automatic saving of information relating to the manual operation.

11. System according to claim 10, **characterized in that** the validation means is a manually operated button (35), the actuation of which triggers said automatic saving of information relating to the manual operation.

12. System according to any one of claims 10 to 11, **characterized in that** said information comprises the time of validation, and a reference allowing the unique identification of the element associated with the manual operation.

13. System according to any one of the preceding claims, **characterized in that** the hand tool (1) is a tightening wrench or screwdriver, a riveting machine, a stapler, a drill, a cutter or a welder.

14. Method for controlling manual operations during production of an assembly of parts, the method comprising the following steps:
- an assembly technician using a portable hand tool (1) to perform manual operations on a plurality of elements (20, 21) of said assembly of parts; and
- determining a location of a manual operation associated with an element (20, 21) by locating the position of said portable hand tool (1) in a three-dimensional coordinate system linked to a three-dimensional model of said assembly of parts, **characterized in that** the method comprises a step of storing in a storage memory a plurality of CAD files allowing the construction of three-dimensional modelled images of the assembly of parts at various stages in production,
and **in that** the determining step comprises image captures by a depth camera (30) belonging to said electronic module (3) attached to said portable hand tool (1) and a step of estimating (110-120) and saving a current position of said portable hand tool (1) by aligning point clouds extracted from at least one current image captured by said depth camera with a mesh or point clouds extracted from a three-dimensional modelled image representative of a current state of said assembly of parts, said three-dimensional modelled image representative of a current state being constructed on the basis of one CAD file from among the plurality of CAD files contained in the storage memory (33a).

15. Method according to claim 14, **characterized in that** said method further comprises a step (130) of estimating a movement of the portable hand tool (1) from a last estimated and saved current position on the basis of measurements delivered by an inertial measurement unit (31) belonging to said electronic module (3), and of estimating at least one updated position of said portable hand tool (1) on the basis of the last current position and said movement.

16. Method according to any one of claims 14 to 15, **characterized in that** said method further comprises a step of automatically transmitting, to a portable user interface (34, 40), a setpoint parameter to be applied for said element according to the location of the associated manual operation from the determining step.

17. Method according to claim 16, **characterized in that** the transmitting step consists in displaying said setpoint parameter on a display screen integrated into said electronic module (3), into a mobile telephone and/or into a portable tablet (4).
